(19) **Europäisches Patentamt**
**European Patent Office**
**Office européen des brevets**

(11) **EP 2 831 305 B1**

(12) **EUROPEAN PATENT SPECIFICATION**

(45) Date of publication and mention
of the grant of the patent:
**02.03.2016 Bulletin 2016/09**

(21) Application number: **13712692.6**

(22) Date of filing: **27.03.2013**

(51) Int Cl.:
***C23C 14/24*** (2006.01)

(86) International application number:
**PCT/EP2013/000919**

(87) International publication number:
**WO 2013/143692 (03.10.2013 Gazette 2013/40)**

(54) **METHOD AND APPARATUS FOR FEEDING LIQUID METAL TO AN EVAPORATOR DEVICE**

VERFAHREN UND VORRICHTUNG ZUM ZUFÜHREN VON FLÜSSIGMETALL ZU EINER VERDAMPFERVORRICHTUNG

PROCÉDÉ ET APPAREIL POUR L'INTRODUCTION DE MÉTAL LIQUIDE DANS UN DISPOSITIF ÉVAPORATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2012 EP 12002348**

(43) Date of publication of application:
**04.02.2015 Bulletin 2015/06**

(73) Proprietors:
• **Tata Steel Nederland Technology B.V.**
**NL-1951 JZ VELSEN-NOORD (NL)**
• **Sidrabe, Inc.**
**LV-1073 Riga (LV)**
• **Posco**
**Pohang-si, Gyeongsangbuk-do 790-300 (KR)**

(72) Inventors:
• **PIPKEVICS, Grigori**
**LV-2130 Riga Region (LV)**

• **ZEILIA, Roberts**
**LV-1079 Riga (LV)**
• **GELFGATS, Jurijs**
**LV-2010 Jurmala (LV)**
• **BOJAREVICS, Andris**
**LV-1050 Riga (LV)**
• **GOODENOUGH, Mark, Robert**
**NL-1970 CA Ijmuiden (NL)**
• **BAPTISTE, Laurent, Christophe, Bernard**
**NL-1970 CA Ijmuiden (NL)**
• **MAALMAN, Theodorus, Franciscus, Jozef**
**NL-1970 CA Ijmuiden (NL)**

(74) Representative: **Blauw, Frans Gerard**
**Tata Steel Nederland Technology BV**
**Group Intellectual Property Services - 3G.37**
**P.O. Box 10000**
**1970 CA IJmuiden (NL)**

(56) References cited:
**EP-A2- 0 184 338    WO-A1-2005/116290**
**JP-A- 59 177 370    KR-A- 20110 034 420**

**Description**

FIELD OF THE INVENTION

The invention relates to a method and apparatus for feeding a liquid metal to an evaporator device in a vacuum chamber. Such an evaporator is for instance used in a physical vapour deposition (PVD) process wherein a metal vapour is deposited on a substrate such as a steel strip.

BACKGROUND OF THE INVENTION

In PVD processes and more in particular in continuous or semi-continuous PVD processes it is necessary to provide a stable supply of liquid metal to the evaporator device wherein the supply is in close balance with the liquid metal evaporated in the evaporator device. This is particularly demanding with high speed PVD processes such as the deposition of evaporated metal on steel strip.

An apparatus for feeding liquid material to an evaporator device for such PVD processes is disclosed in patent application KR20110034420. This known apparatus is provided with means to measure the level of the liquid metal in a supply vessel, which measurements are fed to a control unit. Processing of the measured changes in the liquid metal level gives the flow rate of the liquid metal to the evaporator device. Any mismatch of said flow rate with the demand of liquid metal in the evaporator device results in a control signal to a device for adjusting the flow rate of liquid metal. The device for adjusting the flow rate of liquid metal comprises a conical element on a rod end which can be moved by an electrical motor with respect to the open end of a feed tube submerged in the liquid metal in the supply vessel therewith adjusting the flow rate.

Adjusting the flow rate of the liquid metal on basis of measured changes of the level of the liquid metal in the vessel does not allow for immediate and precise adjustment of the flow rate.

In WO2005/116290 an apparatus for feeding liquid metal to an evaporator device is disclosed wherein an electromagnetic pump is used to feed the liquid metal to the evaporator device and wherein a circuit comprising a separate liquid metal reservoir with level sensors is used to adjust the flow rate of the liquid metal to the evaporator device.

OBJECTIVES OF THE INVENTION

It is an objective of the present invention to provide a method and apparatus which allows for immediate adjustment of the flow rate of liquid metal supplied to the evaporator device.

It is a further objective of the present invention to provide a method and apparatus which allows for immediate adjustment of the flow rate of liquid metal supplied to the evaporator device dependent on the demand of liquid metal in the evaporator device.

It is another objective of the present invention to provide a method and apparatus wherein fluctuations in the pressure exerted on the liquid metal in the supply are controlled.

It is another objective of the present invention to provide a method and apparatus which allows for immediate adjustment of the flow rate of liquid Zn and Zn-alloys, including Zn-Mg, to the evaporator device.

It is another objective of the present invention to provide a method and apparatus which require a minimum of devices in direct contact with the flow of liquid metal to the evaporator device.

It is still another objective of the present invention to provide an apparatus which is relatively simple and can be manufactured cost effectively.

DESCRIPTION OF THE INVENTION

According to a first aspect of the invention one or more of the objectives of the invention are realized by providing a method to supply liquid metal from a vessel for containing liquid metal through a feed tube to an evaporator device in a vacuum chamber wherein the liquid metal is supplied under pressure such that the flow rate of the supplied liquid metal without regulation is larger than the demand of liquid metal in the evaporator device and wherein the flow rate is regulated by generating a counter-pressure in the liquid metal in the feed tube by means of an electromagnetic pump dependent on the demand of liquid metal in the evaporator device.

According to this method the pressure exerted on the liquid metal is always such that the flow rate of liquid metal resulting from the exerted pressure is larger than the demand of liquid metal from the evaporator device and in order to meet the demand the flow rate is regulated by generating a counter-pressure in the supply of liquid metal. When the flow rate of the liquid metal is regulated to the amount required by the evaporator device, the flow rate has only to be regulated to control any deviations in the pressure exerted on the liquid metal in the feed tube.

The term 'metal' as used throughout the description shall mean both metal and metal alloy unless explicitly indicated differently.

According to another aspect of the invention it is provided that the liquid metal in the vessel for containing liquid metal is pressurised by means of an inert gas, such as Argon gas.. In this case the gas pressure is monitored and kept within a range that fulfils the requirement that without the counter-pressure there is always a sufficient flow of liquid metal towards the vacuum chamber. The net pressure of the liquid metal at the start of the feed tube is equal to the difference of the gas pressure in the liquid metal supply vessel, the vacuum pressure in the vacuum chamber and the sum of the hydrostatic pressure of the melt and the counter-pressure generated with the electromagnetic pump.

The gradual decrease of the liquid level in the liquid metal supply vessel moves the pressure balance to decreasing the flow. This is corrected by adjusting the counter-pressure of the electromagnetic pump, which can be done faster and more precise than with adjusting the inert gas pressure.

Such electromagnetic pumps are known in the industry and have the advantage that pump flow rates are very controllable and allow instantaneous changes in the flow rate.

If the vessel for containing liquid metal is also used as a melting furnace then the hydrostatic liquid metal pressure will also change when new metal is fed into the vessel. These variations in the hydrostatic pressure can easily be adjusted with the electromagnetic pump.

According to a further aspect of the invention a liquid metal circulation circuit is provided comprising the vessel for containing liquid metal, an electromagnetic circulation pump connected to the vessel for containing liquid metal and the feed tube, an overflow tube connected to the feed tube between the electromagnetic circulation pump and the electromagnetic pump and extending in upward direction with an overflow opening of the overflow tube in the vessel for containing liquid metal, wherein the column of liquid metal in the overflow tube provides a constant pressure on the liquid metal in the feed tube. The column of liquid metal in the overflow tube forms a pressure head on the liquid metal in the feed tube large enough to generate a supply of liquid metal to the evaporator device that is larger than the demand of liquid metal in the evaporator device. The flow rate of the supply is regulated with the electromagnetic pump. The circulation circuit with such a pressure head provides a pressure circuit with no or only minor variation in the pressure exerted on the supply of liquid metal.

The electromagnetic circulation pump is needed to always have the full column of liquid metal in the overflow tube and to supply sufficient liquid metal from the buffer vessel into the feed tube.

The buffer vessel has to be refilled when a certain minimum level is reached. Accordingly it is provided that liquid metal is supplied from a liquid metal supply vessel to the vessel for containing liquid metal and wherein the liquid metal in the liquid metal supply vessel is pressurised by means of an inert gas. The pressure on the liquid metal in the supply vessel should be such that the buffer vessel can be refilled to the required level sufficiently fast to prevent any disruption in the supply to the evaporator device. The vessel for containing liquid metal will be filled up to a level below the overflow opening of the overflow tube. In this setup variations in the pressure of the liquid metal in the supply vessel have no influence on the supply of liquid metal since the pressure head realized with the column of liquid metal in the overflow tube provides a constant or more or less constant pressure.

The liquid metal is supplied from a supply vessel to the vessel for containing liquid metal via a supply tube connecting the supply vessel directly with the vessel for containing liquid metal or connecting to the feed tube.

Instead of using a pressurised supply vessel it is also possible to refill the vessel for containing liquid metal by simply using gravity and let the liquid metal flow from a higher positioned supply vessel to a lower positioned vessel for containing liquid metal.

All tubes that are in direct contact with the liquid metal are made of a material or have a lining of a material that can withstand the temperatures of the liquid metal and the possible action of the liquid metal on the tube or the tube lining. Such materials include graphite, ceramics, tungsten and some stainless steels.

In order to regulate the flow rate of the liquid metal the actual flow rate has to be known. To that end, according to the invention, the flow rate of liquid metal in the feed tube is measured by means of a flow meter. In the first configuration this could be done at either side of the circulation pump, in the second configuration with the circulation circuit this is done between the electromagnetic pump and the evaporator device. The successive measurements of the flow rate are fed to the control unit, compared with the required flow rate and based on said comparison the electromagnetic pump is controlled. The required flow rate can be established in a number of ways. For instance based on the process parameters of the PVD process comprising required thickness of the deposited layer, the transport speed of the substrate, the heating energy used in the evaporator device. More in particular, in the case of inductive heating of the melt, the required flow rate can be established from the electrical power parameters of the induction coil and/or melt, such as the frequency of the current induced in the melt in the crucible, or in the levitated melt if a levitation evaporation process is used.

According to the invention the flow rate of liquid metal in the feed tube is determined by determining the flow velocity of the liquid metal in the feed tube with an induction flow meter by measuring the induced voltage in the liquid metal by means of electrodes embedded in the wall of the feed tube, wherein the wall of the feed tube at that location is electrically conductive.

With an induction flow meter as normally used the electrodes of the induction meter protrude to the wall of a non conductive tube and are in direct contact with the conductive liquid. With the electrodes changes in the induced voltage are measured which are dependent of the magnetic flux density of a magnetic field provided by permanent magnets or generated by means of electromagnetic coils in the induction flow meter, the distance between the electrodes and the flow velocity of the liquid metal.

With some of the liquid metals to be fed to the evaporator device the temperature may be rather high, such as with liquid Zn or a liquid Zn-Mg alloy. With the higher temperatures of liquid Zn or a liquid Zn-Mg alloy the electrodes would show excessive wear and would need to be replaced after a short time. To overcome that problem the electrodes are embedded in the wall, therewith avoiding direct contact with the liquid metal. The necessary electrical contact with the liquid metal is realized by providing an electrical conductive tube wall portion at least at the location of the embedded electrodes.

The electrical conductive tube wall portion should consist of a material that is capable to withstand the temperature of liquid Zn or a liquid Zn-Mg alloy for a prolonged time. Good results have been realized with graphite as an electrical conductive tube wall portion, which is capable of withstanding high temperatures and also has a sufficiently low resistivity to allow for reliable measurements of flow velocity with the embedded electrodes.

Since the feed tube is over its entire length in direct contact with liquid metal the feed tube is preferably of graphite or has a graphite lining. Also with this configuration wherein the graphite of the feed tube electrically connects the electrodes of the flow meter it turned out that measurements are reliable and in good correspondence with the flow velocity of the liquid metal. According to a further aspect the invention also provides an apparatus for feeding liquid metal to an evaporator device in a vacuum chamber, the apparatus comprising a vessel for containing liquid metal, a feed tube from the vessel for containing liquid metal to the evaporator device, wherein the liquid metal is fed under pressure such that the flow rate of the liquid metal is larger than the demand in the evaporator device, an electromagnetic pump, control means to control the electromagnetic pump and wherein the flow rate of the liquid metal is regulated by controlling the electromagnetic pump to generate a counter-pressure in the liquid metal in the feed tube.

In order to feed the liquid metal under pressure to the evaporator device supply means are provided to supply an inert gas under pressure to the vessel for containing liquid metal to pressurise the liquid metal in the vessel for containing liquid metal.

The above setup is completed with an induction flow meter to determine the flow rate of liquid metal in the feed tube. This setup has the advantage of having a very limited number of components and at the same time easily provides the required precision in the control of the flow rate in the supply of the liquid metal.

Additionally means may be provided to keep the pressure exerted on the liquid metal in the supply vessel by means of the inert gas as constant as possible. Such means would include inert gas pressure meter means and control means to regulate the inert gas supply.

In a further embodiment provided according to the invention a liquid metal circulation circuit is provided in the feed tube comprising the vessel for containing liquid metal, an electromagnetic circulation pump in the feed tube, an overflow tube connected to the feed tube between the electromagnetic circulation pump and the electromagnetic pump, the overflow tube extending in upward direction with an overflow opening of the overflow tube in the vessel for containing liquid metal, wherein the column of liquid metal in the overflow tube provides a constant pressure on the liquid metal in the feed tube which is sufficient to provide a flow rate of the liquid metal that is larger than the demand in the evaporator device.

According to still a further aspect a shut-off valve is provided in the feed tube between the electromagnetic pump and the vacuum chamber. This further shut-off valve is used to shut-off the supply to the evaporator device completely, for instance when filling the buffer vessel for the first time or when the evaporation process cycle is about to end.

In order to be able to easily control the volume of liquid metal in the vessel for containing liquid metal a level sensor is provided to measure the level of liquid metal in the vessel for containing liquid metal. This level sensor may be a sensor that is in direct contact with the liquid metal in the vessel or could be an electronic sensor designed to take measurements without any physical contact with the liquid metal. The measured levels of liquid metal are fed to the control unit.

## BRIEF DESCRIPTION OF THE DRAWINGS

The invention will be further explained by the examples shown in the drawing, in which:

fig. 1 shows a schematic layout of the apparatus to feed liquid metal to an evaporator device in a vacuum chamber, the apparatus comprising a vessel for containing liquid metal, a feed tube, an electromagnetic pump, an induction flow meter, and a control unit,

fig. 2 shows a schematic layout of the apparatus to feed liquid metal to an evaporator device in a vacuum chamber wherein the vessel for containing liquid metal is part of a circulation circuit with an electromagnetic circulation pump and an overflow tube, and

fig.3    shows schematically a cross-section through the induction flow meter and the feed tube.

## DETAILED DESCRIPTION OF THE DRAWINGS

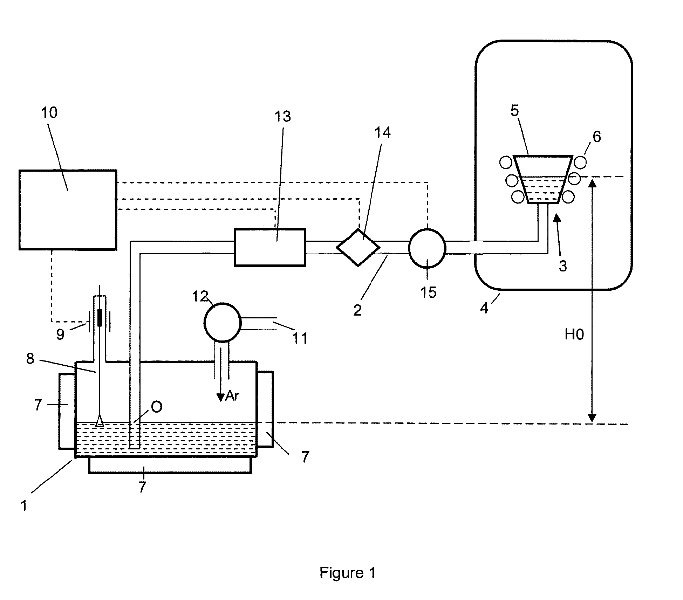

The apparatus shown schematically in fig. 1 has a vessel for containing liquid metal 1 from which through feed tube 2 liquid metal is fed to evaporator device 3 in vacuum chamber 4. In this example the evaporator device is a crucible 5 with a water cooled induction coil 6 for further heating and evaporating the liquid metal in the crucible.

Instead of an evaporator with a crucible it is also possible to use an evaporator wherein the supplied liquid metal is held in levitation (EML-PVD) while it is vaporized, or to use a jet vapour deposition setup (JET-PVD).

The vessel for containing liquid metal 1 is provided with heating devices 7 to heat the metal in the vessel to the required temperature and to keep it at that temperature. The vessel for containing liquid metal 1 could also be used as a combination of melting furnace and vessel for containing liquid metal. A float sensor 8 is provided to monitor the level of liquid metal in the vessel for containing liquid metal 1. The float sensor 8 has signal means 9 that provide a signal corresponding to the level of the liquid metal in the vessel for containing liquid metal 1 to a control unit 10.

A supply line 11 for an inert gas, such as Argon, with a shut-off valve 12 is provided to feed the gas under pressure to the vessel for containing liquid metal 1 to pressurize the liquid metal in the vessel. Gas pressure sensors (not shown) are provided to monitor the gas pressure in the vessel for containing liquid metal 1. The pressure exerted by the inert gas on the liquid metal is taken higher than needed for the required flow rate of liquid metal to evaporator device 3.

In feed tube 2 an electromagnetic pump 13, an induction flow meter 14 and a shut-off valve 15 are provided, which are each connected to control unit 10.

In operation the pressurized liquid metal flows from the vessel for containing liquid metal 1 through feed tube 2 to the evaporator device 3. The flow rate is measured frequently or continuously and fed to control unit 10 where it is compared with the required flow rate. If necessary the flow rate is regulated by controlling electromagnetic pump 13. In operation the driving pressure, ΔP, of the feeding system is determined by the balance of all pressures in point "O":

$$\Delta P = P_{Ar} - (P13 + \rho * g * H0 + P_{VACUUM}),$$

wherein $P_{Ar}$ is the Argon pressure in the liquid metal vessel, P13 the pressure developed by the electromagnetic pump 13, p * g * H0 (the specific mass (p) of the liquid metal * acceleration of gravity (g) * the height difference (H0)) is the hydrostatic pressure generated by the liquid metal from the crucible down to the liquid level in the liquid metal vessel and $P_{VACUUM}$ is the pressure above the zinc melt in the vacuum chamber.

Since the Ar-pressure in the vessel for containing liquid metal is taken such that the flow rate as a result of said pressure will always be higher than the required flow rate the electromagnetic pump 13 is operated to generate a counter-pressure in feed tube 2 to arrive at the required flow rate.

By using the electromagnetic pump 13 in counter-pressure a very fast and accurate adjustment of the flow rate is possible, which is far more accurate and faster than adjusting the flow rate by controlling the pressure of the inert gas in supply vessel 1.

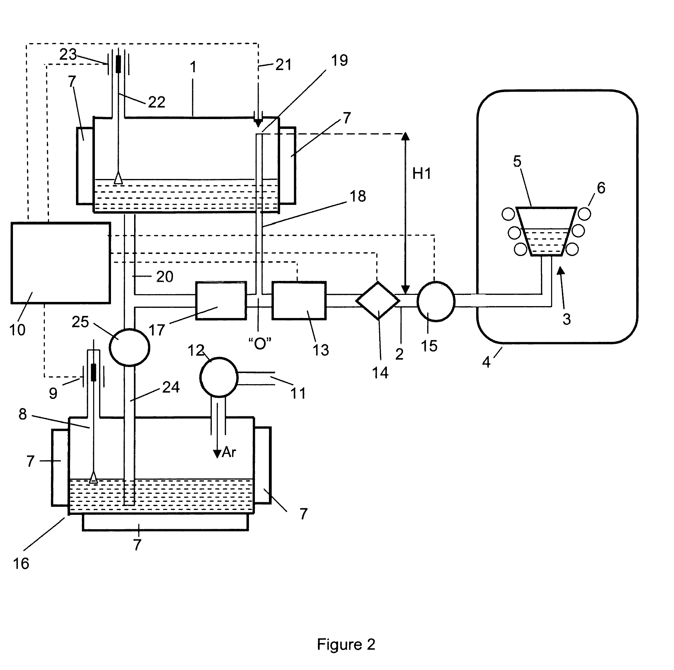

In fig. 2 an embodiment is shown wherein the vessel for containing liquid metal 1 is part a circulation circuit that provides a constant pressure head at point "O" in feed tube 2. This circulation circuit comprises the vessel for containing liquid metal 1, an electromagnetic circulation pump 17, an overflow tube 18 connected to the feed tube 2 between electromagnetic circulation pump 17 and electromagnetic pump 13, the overflow tube 18 having its overflow opening 19 within the vessel for containing liquid metal 1, and wherein the side of the electromagnetic circulation pump 17 opposite of the side connected to the overflow tube 18 is connected by means of a tube 20 to the vessel for containing liquid metal 1.

The part of overflow tube 18 that is within the vessel for containing liquid metal 1 may also be a separate compartment within the vessel to which the tube connects at the outside of vessel 1.

The overflow tube 18 is provided with an overflow sensor 21 at the overflow opening 19. The overflow sensor 21, which could be a contact sensor, is connected to control unit 10. The vessel for containing liquid metal 1 is provided with a float sensor 22 to monitor the level of liquid metal in the vessel 1. The float sensor 22 has signal means 23 that provide a signal corresponding to the level of the liquid metal in the vessel for containing liquid metal 1 to control unit 10.

The vessel for containing liquid metal 1 is further provided with heating devices 7 to keep the liquid metal in the buffer vessel at the required temperature.

In this example a liquid metal supply vessel 16 is connected to the vessel for containing liquid metal 1 by means of a connecting tube 24, which in the given example connects to tube 20 with which the electromagnetic circulation pump 17 is connected to the vessel for containing liquid metal 1. In this connecting tube 24 a shut-off valve 25 is provided by means of which liquid metal supply vessel 16 can be separated from the other part of the supply circuit. This has the advantage of allowing the connection of a fresh supply vessel with liquid metal without the necessity of stopping the evaporation process.

Instead of connecting tube 24 downstream of electromagnetic circulation pump 17 it could also be connected to the feed tube in between electromagnetic circulation pump 17 and electromagnetic pump 13. Another option is to connect the liquid metal supply vessel 16 to the vessel for containing liquid metal 1 via a direct connecting tube, that is without connecting to tube 20 or feed tube 2.

Further heating means (not shown) are provided to heat feed tube 2, overflow tube 18, tube 20 and connecting tube 24. Feed tube 2, overflow tube 18, tube 20 and connecting tube 24 or the lining of these tubes should be able to withstand the possible action of the liquid metal on the tube material as well as the temperature of the liquid metal. With Zn or Zn/10%Mg as liquid metal the temperatures are respectively above 420°C and above 600°C. Moreover, liquid Zn or Zn/10%Mg act aggressively on most metals or metal alloys, resulting in that only a limited number of materials can be used for these tubes or linings for these tubes, which include graphite, ceramics, tungsten and some stainless steels.

The system operates in the following way. After heating the liquid metal in liquid metal supply vessel 16 or, if vessel 16 is also used as a melting furnace, after melting and heating the metal in liquid metal supply vessel 16, the pressure of the inert gas is raised to the required pressure by opening shut-off valve 12. By opening shut-off valve 25 liquid metal is forced out of liquid metal supply vessel 16 and, via tube 24, is fed through tube 20 to the vessel for containing liquid metal 1 up to the set level which is monitored by means of level sensor 22. Thereafter shut-off valve 25 in connecting tube 24 is closed and electromagnetic circulation pump 17 is started resulting in that the overflow tube 18 is filled and liquid metal flows through overflow opening 19 and returns into the vessel for containing liquid metal 1. This is monitored by means of overflow sensor 21 since in order to have a constant pressure head at point "O" overflow tube 18 should remain completely filled. With the liquid metal circulating in this circuit the pressure head formed by the column H1 of liquid metal will be constant in height throughout the emptying of the vessel for containing liquid metal 1.

After the circulation circuit for the liquid metal is put into operation the shut-off valve 15 may be opened after which the liquid metal flows through feed tube 2 into crucible 5 of evaporator 3. The flow rate is then measured by means of induction flow meter 14 and the flow rate is adjusted and stabilized to the required flow rate by means of electromagnetic pump 13. Since the pressure head formed by the column H1 of liquid metal generates a flow rate larger than the required flow rate electromagnetic pump 13 will operate continuously in counter-pressure.

The initial state of the feeding system is determined by the balance of all pressures in point "O":

$$P17 + P13 + \rho * g * H1 = 0,$$

wherein P17 and P13 are the respective pressures developed by electromagnetic circulation pump 17 and electromagnetic pump 13, and p * g * H1 (the specific mass (p) of the liquid metal * acceleration of gravity (g) * the height (H1)) is the pressure head provided by the column of liquid metal in overflow tube 18 at point "O".

Separation of the liquid metal supply vessel 16 from the vessel for containing liquid metal 1 and the constant pressure feeding system allows to refill the liquid metal supply vessel with liquid metal, or with solid metal if the liquid metal supply vessel is also used as melting furnace, without interruption or disturbance of the liquid metal supply to the evaporator device 3.

It is also possible to connect a single constant pressure circuit to several liquid metal supply vessels or combined supply and melting vessels, which have to be put out of operation periodically in order to clean these from slag and accumulated impurities, without that the production process has to be interrupted.

The electromagnetic circulation pump 17 and the electromagnetic pump 13 can be switched such that both pumps generate flow in the same direction. This allows to drain all liquid metal from evaporator device 3 and the vessel for containing liquid metal 1 back to liquid metal supply vessel 16 in a short time in case of an emergency situation wherein the PVD process has to be stopped.

In both the embodiments according to fig.1 and fig.2 lifting means may be provided to displace the vessel for containing liquid metal or the liquid metal supply vessel in up- and downward direction with respect to the feed tube or connecting tube, as the case may be. This allows to completely drain the feed or connecting tube when the system is put out of operation so that the tube does not get blocked with solidified metal.

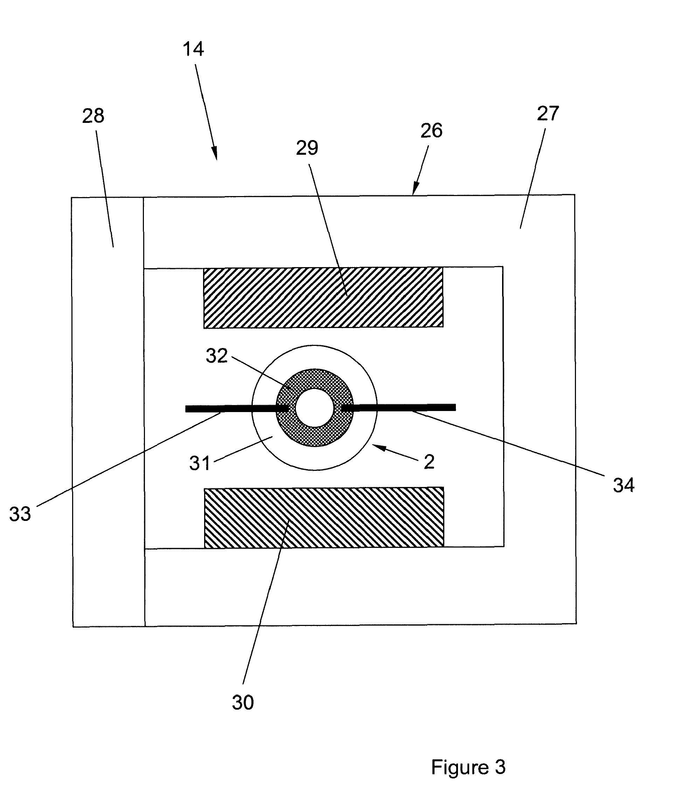

Fig. 3 shows a cross-section through the induction flow meter 14 that is used to determine the flow ratio in feed tube 2. In this example flow meter 14 comprises a rectangular shaped magnetic frame 26 of ferromagnetic material with two permanent magnets 29, 30 at the inside of opposite legs of magnetic frame 26. The magnetic frame is built up with a U-shaped part 27 and a detachable part 28 connecting the outer ends of U-shaped part 27. Because of this construction it will be easier to position or remove the flow meter.

Other constructions that allow easy replacement of a flow meter would be with a tube portion fixed to the flow meter that connects at opposite sides with the feed tube. However, with a feed system of liquid metal such a construction with two further connections is not preferred because of the complexities with these high temperature feed systems.

The permanent magnets 29 and 30, which could for instance be Nd-Fe-B or Sm-Co based permanent magnets, form opposite poles in the magnetic circuit providing an electrical field with about straight magnetic field lines within the inside of feed tube 2. Instead of permanent magnets also a system with electromagnetic coils to generate a magnetic field could be used.

In the figure the feed tube 2 has respectively an outside and an inside part 31, 32. The inside part 32 is made of graphite, more in particular of amorphous graphite. With the feeding of liquid metal it depends on the temperatures of the liquid metal whether or not the whole inside of the feed tube 2 should be made of graphite. With liquid Zn or liquid Zn-Mg, with up to 10% Mg, the respective melting temperatures will be about 420°C and about 600°C and in these cases the inside part 32 of the feed tube should be made of graphite in order to withstand the temperatures thereof.

The outside part 31 may comprise a tube against which the graphite of the inside part is applied as a liner, insulation means and if necessary heating means to keep the feed tube at a certain minimum temperature.

Two electrodes 33, 34 have been provided of which at least the outer ends are in a plane at about a right angle with the magnetic field lines through the feed tube. The outer ends are embedded in the graphite of the inside part 32 of the feed tube in order to avoid direct contact with the liquid metal which would lead to rapid wear of the electrodes, especially with the high temperatures of liquid Zn and Zn-Mg. Preferably these electrodes are made of tungsten.

In known induction flow meters the electrodes are in direct contact with a conductive liquid in a feed tube, wherein the feed tube is of a non-conductive material. The measured induced voltage is dependent on the magnetic flux density, the distance between the outer ends of the electrodes and the flow velocity of the conductive liquid.

With the flow meter according to the invention the outer ends of the electrodes are not in direct contact with the conductive liquid because of the reasons given above. The necessary contact with the conductive liquid is through the graphite of inside part 32, which is possible because amorphous graphite has sufficiently low resistivity to act as a conductor. However, because of the conductivity of the amorphous graphite there will also be contact between the electrodes through the graphite part of the feed tube. With a voltmeter attached to the electrodes the resulting measuring circuit will comprise parallel current components through the feed tube and between the outer end of the electrodes through the liquid metal. The last current component is in fact through the liquid metal and through a small part of graphite corresponding to the distance between the outer ends of the electrodes and the inside of the feed tube with the liquid metal. Although the measured voltages are relatively low, these can be reliably measured with present day voltmeters suitable to measure in nV ranges. With the measured voltages and changes in voltages the flow velocity and subsequently the flow ratio can be determined with sufficient precision to be able to control electromagnetic pump 13 and therewith the supply to the evaporator device within sufficiently narrow ranges.

**Claims**

1. Method to supply liquid metal from a vessel for containing liquid metal through a feed tube to an evaporator device in a vacuum chamber wherein the liquid metal is supplied under pressure **characterised in that** the liquid metal is supplied under pressure such that the flow rate of the supplied liquid metal without regulation is larger than the demand of liquid metal in the evaporator device and wherein the flow rate is regulated by generating a counter-pressure in the liquid metal in the feed tube by means of an electromagnetic pump dependent on the demand of liquid metal in the evaporator device.

2. Method according to claim 1, wherein the liquid metal in the vessel for containing liquid metal is pressurised by means of an inert gas.

3. Method according to claim 1, wherein a liquid metal circulation circuit is provided comprising the vessel for containing liquid metal, an electromagnetic circulation pump connected to the vessel for containing liquid metal and the feed tube, an overflow tube connected to the feed tube between the electromagnetic circulation pump and the electromagnetic pump and extending in upward direction with an overflow opening of the overflow tube in the vessel for containing liquid metal, wherein the column of liquid metal in the overflow tube provides a constant pressure on the liquid metal in the feed tube.

4. Method according to one or more of claims 1-3, wherein the flow rate of liquid metal in the feed tube is determined and wherein the electromagnetic pump is controlled on basis of the determined flow rate and the demand of liquid metal for the evaporator device.

5. Method according to claim 4, wherein the flow rate of liquid metal in the feed tube is determined by determining the flow velocity of the liquid metal in the feed tube with an induction flow meter by measuring the induced voltage in the liquid metal by means of electrodes embedded in the wall of the feed tube, wherein the wall of the feed tube at that location is electrically conductive.

6. Method according to claim 4, wherein liquid metal is supplied from a liquid metal supply vessel to the vessel for containing liquid metal and wherein the liquid metal in the liquid metal supply vessel is pressurised by means of an inert gas.

7. Apparatus for feeding liquid metal to an evaporator device in a vacuum chamber, the apparatus comprising a vessel for containing liquid metal, a feed tube from the vessel for containing liquid metal to the evaporator device, an electromagnetic pump and control means to control the electromagnetic pump and means to pressurise the liquid metal in the vessel for containing liquid metal, **characterised in that** an induction flow meter is provided to measure the flow velocity of liquid metal in the feed tube.

8. Apparatus according to claim 7, wherein supply means are provided to supply an inert gas under pressure to the vessel for containing liquid metal to pressurise the liquid metal in the vessel for containing liquid metal.

9. Apparatus according to claim 7, wherein a liquid metal circulation circuit is provided in the feed tube comprising the vessel for containing liquid metal, an electromagnetic circulation pump in the feed tube, an overflow tube connected to the feed tube between the electromagnetic circulation pump and the electromagnetic pump, the overflow tube extending in upward direction with an overflow opening of the overflow tube in the vessel for containing liquid metal, wherein the column of liquid metal in the overflow tube provides a constant pressure on the liquid metal in the feed tube which is sufficient to provide a flow rate of the liquid metal that is larger than the demand in the evaporator device.

10. Apparatus according to one or more of claims 7-9, wherein electrodes of the induction flow meter are embedded in an electrically conductive wall of the feed tube.

11. Apparatus according to one or more of claims 7-10, wherein a shut-off valve is provided in the feed tube between the electromagnetic pump and the vacuum chamber.

12. Apparatus according to one or more of claims 7-11, wherein a level sensor is provided to measure the level of liquid metal in the vessel for containing liquid metal.

13. Apparatus according to one or more of claims 7-12, wherein a liquid metal supply vessel is connected to the vessel for containing liquid metal.

14. Apparatus according to claim 13, wherein a connecting tube from the liquid metal supply vessel connects to the feed tube upstream of the electromagnetic pump and wherein a shut off valve is provided in the connecting tube.

**Patentansprüche**

1. Verfahren zum Zuführen von Flüssigmetall aus einem Behälter für Flüssigmetall über eine Zuleitung zu einer Verdampfervorrichtung in einer Vakuumkammer, wobei das Flüssigmetall unter Druck zugeführt wird, **gekennzeichnet dadurch, dass** das Flüssigmetall unter Druck zugeführt wird, so dass die Flussrate des zugeführten Flüssigmetalls ohne Regulierung höher ist als der Bedarf von Flüssigmetall in der Verdampfervorrichtung, und wobei die Flussrate reguliert wird, indem mittels einer elektromagnetischen Pumpe in Abhängigkeit von dem Bedarf von Flüssigmetall in der Verdampfervorrichtung ein Gegendruck im Flüssigmetall in der Zuleitung erzeugt wird.

2. Verfahren gemäß Anspruch 1, wobei das Flüssigmetall in dem Behälter für Flüssigmetall mit einem Edelgas unter Druck gesetzt wird.

3. Verfahren gemäß Anspruch 1, wobei ein Flüssigmetallzirkulationskreislauf dargeboten wird, der den Behälter für Flüssigmetall, eine elektromagnetische Zirkulationspumpe, die mit dem Behälter für Flüssigmetall und der Zuleitung verbunden ist, und ein Überlaufrohr, das zwischen der elektromagnetischen Zirkulationspumpe und der elektromagnetischen Pumpe mit dem Behälter für Flüssigmetall verbunden ist und sich nach oben erstreckt, mit einer Überlauföffnung des Überlaufrohres im Behälter für Flüssigmetall, umfasst, wobei die Säule für Flüssigmetall im Überlaufrohr einen konstanten Druck auf das Flüssigmetall in der Zuleitung ausübt.

4. Verfahren gemäß einem oder mehreren der Ansprüche 1-3, wobei die Flussrate des Flüssigmetalls in der Zuleitung bestimmt wird und wobei die elektromagnetische Pumpe basierend auf der festgelegten Flussrate und dem Bedarf von Flüssigmetall in der Verdampfervorrichtung gesteuert wird.

5. Verfahren gemäß Anspruch 4, wobei die Flussrate des Flüssigmetalls in der Zuleitung bestimmt wird, indem die Flussgeschwindigkeit des Flüssigmetalls in der Zuleitung mit einem Induktionsdurchflussmesser bestimmt wird, indem die induzierte Spannung im Flüssigmetall anhand von Elektroden, die in die Wand der Zuleitung eingelassen werden, gemessen wird, wobei die Wand der Zuleitung an der entsprechenden Stelle elektrisch leitend ist.

6. Verfahren gemäß Anspruch 4, wobei Flüssigmetall von einem Flüssigmetallzuführungsbehälter zum Behälter für Flüssigmetall geführt wird und wobei das Flüssigmetalls im Flüssigmetallzuführungsbehälter mit einem Edelgas unter Druck gesetzt wird.

7. Gerät zur Zuführung von Flüssigmetall zu einer Verdampfervorrichtung in einer Vakuumkammer, wobei das Gerät einen Behälter für Flüssigmetall, eine Zuleitung vom Behälter für Flüssigmetall zur Verdampfervorrichtung, eine elektromagnetische Pumpe und Kontrollmittel zur Steuerung der elektromagnetischen Pumpe und Mittel, um das Flüssigmetall im Behälter für Flüssigmetall unter Druck zu setzen, umfasst, **gekennzeichnet dadurch, dass** ein Induktionsdurchflussmesser dargeboten wird, um die Flussgeschwindigkeit des Flüssigmetalls in der Zuleitung zu messen.

8. Gerät gemäß Anspruch 7, wobei Zuführungsvorrichtungen dargeboten werden, um dem Behälter für Flüssigmetall unter Druck ein Edelgas zuzuführen, um das Flüssigmetall im Behälter für Flüssigmetall unter Druck zu setzen.

9. Gerät gemäß Anspruch 7, wobei in der Zuleitung ein Flüssigmetallzirkulationskreislauf dargeboten wird, der den Behälter für Flüssigmetall, eine elektromagnetische Zirkulationspumpe in der Zuleitung und ein Überlaufrohr, das zwischen der elektromagnetischen Zirkulationspumpe und der elektromagnetischen Pumpe mit der Zuleitung verbunden ist, wobei sich das Überlaufrohr nach oben erstreckt, mit einer Überlauföffnung des Überlaufrohres im Behälter für Flüssigmetall, umfasst, wobei die Säule für Flüssigmetall im Überlaufrohr einen konstanten Druck auf das Flüssigmetall in der Zuleitung ausübt, der ausreicht, um eine Flussrate des Flüssigmetalls zu bieten, die höher ist als der Bedarf in der Verdampfervorrichtung.

10. Gerät gemäß einem oder mehreren der Ansprüche 7-9, wobei Elektroden des Induktionsdurchflussmessers in eine elektrisch leitende Wand der Zuleitung eingelassen sind.

11. Verfahren gemäß einem oder mehreren der Ansprüche 7-10, wobei in der Zuleitung zwischen der elektromagnetischen Pumpe und der Vakuumkammer ein Absperrventil vorgesehen ist.

12. Verfahren gemäß einem oder mehreren der Ansprüche 7-11, wobei ein Füllstandssensor dargeboten wird, um den Stand des Flüssigmetalls im Behälter für Flüssigmetall zu messen.

13. Verfahren gemäß einem oder mehreren der Ansprüche 7-12, wobei ein Flüssigmetallzuführungsbehälter mit dem Behälter für Flüssigmetall verbunden ist.

14. Gerät gemäß Anspruch 13, wobei ein Verbindungsrohr vom Flüssigmetallzuführungsbehälter oberhalb der elektromagnetischen Pumpe mit der Zuleitung verbunden ist und wobei im Verbindungsrohr ein Absperrventil vorgesehen ist.

**Revendications**

1. Procédé destiné à fournir un métal liquide à partir d'un réservoir servant à contenir du métal liquide par l'intermédiaire d'un tube d'alimentation vers un dispositif évaporateur dans une chambre à vide, ledit métal liquide étant fourni sous pression, **caractérisé en ce que** le métal liquide est fourni sous pression de sorte que le débit du métal liquide fourni sans régulation soit plus important que la demande en métal liquide dans le dispositif évaporateur, et ledit débit étant régulé par la production d'une contre-pression dans le métal liquide dans le tube d'alimentation au moyen d'une pompe électromagnétique en fonction de la demande en métal liquide dans le dispositif évaporateur.

**2.** Procédé selon la revendication 1, ledit métal liquide dans le réservoir servant à contenir du métal liquide étant mis sous pression au moyen d'un gaz inerte.

**3.** Procédé selon la revendication 1, un circuit de circulation de métal liquide étant pourvu qui comprend le réservoir servant à contenir du métal liquide, une pompe de circulation électromagnétique reliée au réservoir servant à contenir du métal liquide et au tube d'alimentation, un tube de trop-plein relié au tube d'alimentation entre la pompe de circulation électromagnétique et la pompe électromagnétique et s'étendant vers le haut avec un orifice de trop-plein du tube de trop-plein dans le réservoir servant à contenir du métal liquide, la colonne de métal liquide dans le tube de trop-plein assurant une pression constante sur le métal liquide dans le tube d'alimentation.

**4.** Procédé selon une ou plusieurs des revendications 1 à 3, ledit débit de métal liquide dans le tube d'alimentation étant déterminé et ladite pompe électromagnétique étant commandée sur la base du débit déterminé et de la demande en métal liquide pour le dispositif évaporateur.

**5.** Procédé selon la revendication 4, ledit débit de métal liquide dans le tube d'alimentation étant déterminé par la détermination de la vitesse d'écoulement du métal liquide dans le tube d'alimentation avec un débitmètre à induction en mesurant la tension induite dans le métal liquide au moyen d'électrodes intégrées dans la paroi du tube d'alimentation, ladite paroi du tube d'alimentation à cet endroit étant électro-conductrice.

**6.** Procédé selon la revendication 4, ledit métal liquide étant fourni à partir d'un réservoir d'approvisionnement en métal liquide au réservoir servant à contenir du métal liquide et ledit métal liquide dans le réservoir d'approvisionnement en métal liquide étant mis sous pression au moyen d'un gaz inerte.

**7.** Appareil permettant d'alimenter en métal liquide un dispositif évaporateur dans une chambre à vide, l'appareil comprenant un réservoir servant à contenir du métal liquide, un tube d'alimentation allant du réservoir servant à contenir du métal liquide au dispositif évaporateur, une pompe électromagnétique et des moyens de commande pour commander la pompe électromagnétique et des moyens pour mettre sous pression le métal liquide dans le réservoir servant à contenir du métal liquide, **caractérisé en ce qu'**un débitmètre à induction est pourvu pour mesurer la vitesse d'écoulement du métal liquide dans le tube d'alimentation.

**8.** Appareil selon la revendication 7, lesdits moyens d'approvisionnement étant pourvus pour alimenter en gaz inerte sous pression le réservoir servant à contenir du métal liquide afin de mettre sous pression le métal liquide dans le réservoir servant à contenir du métal liquide.

**9.** Appareil selon la revendication 7, ledit circuit de circulation de métal liquide étant pourvu dans le tube d'alimentation comprenant le réservoir servant à contenir du métal liquide, une pompe de circulation électromagnétique dans le tube d'alimentation, un tube de trop-plein relié au tube d'alimentation entre la pompe de circulation électromagnétique et la pompe électromagnétique, le tube de trop-plein s'étendant vers le haut avec un orifice de trop-plein du tube de trop-plein dans le réservoir servant à contenir du métal liquide, ladite colonne de métal liquide dans le tube de trop-plein assurant une pression constante sur le métal liquide dans le tube d'alimentation qui est suffisante pour fournir un débit de métal liquide qui est plus important que la demande dans le dispositif évaporateur.

**10.** Appareil selon une ou plusieurs des revendications 7 à 9, lesdites électrodes du débitmètre à induction étant intégrées dans une paroi électro-conductrice du tube d'alimentation.

**11.** Appareil selon une ou plusieurs des revendications 7 à 10, une vanne d'arrêt étant pourvue dans le tube d'alimentation entre la pompe électromagnétique et la chambre à vide.

**12.** Appareil selon une ou plusieurs des revendications 7 à 11, un capteur de niveau étant pourvu pour mesure le niveau de métal liquide dans le réservoir servant à contenir du métal liquide.

**13.** Appareil selon une ou plusieurs des revendications 7 à 12, ledit réservoir d'approvisionnement en métal liquide étant relié au réservoir servant à contenir du métal liquide.

**14.** Appareil selon la revendication 13, un tube de raccordement partant du réservoir d'approvisionnement en métal liquide étant relié au tube d'alimentation en amont de la pompe électromagnétique et ladite vanne d'arrêt étant pourvue dans le tube de raccordement.

EP 2 831 305 B1

Figure 1

Figure 2

Figure 3

**EP 2 831 305 B1**

**REFERENCES CITED IN THE DESCRIPTION**

**Patent documents cited in the description**

- KR 20110034420

- WO 2005116290 A